# EUROPÄISCHE PATENTSCHRIFT

(11) **EP 3 214 907 B1**
(45) Veröffentlichungstag und Bekanntmachung des Hinweises auf die Patenterteilung: **22.07.2020**
(21) Anmeldenummer: 17158601.9
(22) Anmeldetag: 01.03.2017
(51) Int. Cl.: H05K 5/00, H05K 5/02

(54) **NODEGEHÄUSE UND NODE, ENTHALTEND OPTIONALES DIPLEXFILTER VON AUSSEN STECKBAR**
NODE HOUSING AND NODE, CONTAINING OPTIONAL DIPLEX FILTER WHICH CAN BE CONNECTED EXTERNALLY
BOÎTIER DE NOEUD ET NOEUD, CONTENANT UN FILTRE DIPLEXEUR ENFICHABLE PAR L'EXTÉRIEUR

(30) Priorität: 01.03.2016 DE 102016103663
(43) Veröffentlichungstag der Anmeldung: 06.09.2017
(73) Patentinhaber: Telefonaktiebolaget LM ERICSSON (PUBL), 16483 Stockholm (SE)
(72) Erfinder: VOCKENSPERGER, Simon, 83004 Rosenheim (DE); TOMANEK, Lukas, 83004 Rosenheim (DE); HÄNTSCH, Ralf, 83004 Rosenheim (DE)
(74) Vertreter: Sonnenberg, Fred

(56) Entgegenhaltungen:
- DE-B3-102011 056 564
- US-A- 3 717 813
- US-A1- 2003 035 278
- US-A1- 2005 281 514
- User Teleste: "ACcess Series AC800 Manual", , 3. November 2006 (2006-11-03), Seiten 1-14, XP055272977, Gefunden im Internet: URL:http://www.konturm.ru/catalogy/paspeng /ac800_usermanual_003.pdf [gefunden am 2016-05-17]

## Beschreibung

Die vorliegende Erfindung betrifft das Gebiet der Netzwerktechnik und insbesondere ein Nodegehäuse und ein Node welcher ein solches Nodegehäuse verwendet. Sogenannte Nodes werden in der Netzwerktechnik häufig verwendet und dienen maßgeblich der breitbandigen Übertragung von Signalen. Ein typischer Node ist ein sogenannter Fibernode, welcher dazu dient breitbandig Kabelnetzsignale in beiden Richtungen, d. h. upstream und downstream zu übertragen wobei der Node insbesondere für die optisch/elektrische und elektrisch/optische Wandlung dieser Signale zuständig ist.

Ganz allgemein ist die Erfindung jedoch nicht auf sogenannte Fibrenodes beschränkt, sondern betrifft jeglichen Node bei dem unterschiedliche Übertragungsarten zum Einsatz kommen. Ein typisches Beispiel für einen Fibernode ist beispielhaft bekannt von der Firma Kathrein, vertrieben unter der Bezeichnung ORA 9222-1G2/-1G (Quelle Kathrein Produktkatalog Optical compact receivers for modern HFC networks). Weitere Produkte sind bekannt von Teleste, beispielsweise vertrieben unter der Bezeichnung CXI880 fibre-optik-node. Ein solches Netzwerkbauteil enthält üblicherweise eine Platine mit einer Vielzahl daran befindlicher elektronischer Bauteile. Bei den im Stand der Technik vorbekannten Vorrichtungen, wie z.B. der CXE880 ist die Platine z. B. bereitgestellt mit einer Vielzahl an elektronischen Bauteilen, die die Wandlung von optischen Signalen in HF-Signalen darstellen, wobei an der Platine auch verschiedene Verstellorgane, Testports und beispielsweise auch ein austauschbarer steckfähiger Diplexfilter bereitgestellt ist.

Sämtliche der vorgenannten Bauteile nebst der Testports, wie auch der steckbare Diplexfilter sind üblicherweise in einem metallischen Schirmgehäuse aufgenommen, welches meist dergestalt ausgebildet ist, dass es aus einem Basisteil und einem abnehmbaren, manchmal mit einem scharnierangelengten Deckel verschlossen werden kann. Diese Schirmgehäuse verfügen üblicherweise im Basisteil über Signaleinspeiseöffnungen, z. B. zum Zuführen eines optischen Kabels oder für HF-Anwendungen häufig einen Koaxialanschluss. Wenn der Node nicht wie häufig angetroffen über eine der Signalleitungen selbst mit Strom versorgt wird ist gegebenenfalls eine weitere Öffnung vorgesehen, um eine externe Stromversorgung anschließen zu können, oder um eine interne Stromversorgung mit einer Stromquelle verbinden zu können.

Ansonsten besteht in Anbetracht der gewünschten maximalen Schirmwirkung und auch um ein Eindringen von Feuchtigkeit und Schmutz das Nodegehäuse aus durchgängigen metallischen Wandungen die wie bereits erwähnt z. B. ein Basisteil und einen Deckel ausbilden können.

Wenn eine Einstellung an solch einem Node verändert werden soll oder ein verbauter Diplexfilter oder auch andere elektronische Bauteile oder Bauteilgruppen ausgetauscht werden soll(en) so ist es immer erforderlich das Gehäuse zu öffnen um entsprechend Zugriff auf Kippschalter, Dipschalter, Drehregler, Steckelement, wie z. B. Sicherungen oder auch Diplexfilter erlangen zu können. Auch für das Anschließen von Messgeräten an Testports ist in der Regel ein Öffnen des Gehäuses impliziert. Das Öffnen eines Gehäuses bedarf in der Regel, dass ein qualifizierter Techniker vor Ort eingreifen muss, wobei durch jedes Öffnen des Gehäuses ein potentielles Risiko einer Beschädigung gegeben ist, insbesondere auch von elektronischen Bauteilen auf die gar nicht zugegriffen werden muss, wobei erschwerend in vielen Fällen durch die Handhabungen des Technikers eine Leitungsunterbrechung in Kauf genommen werden muss.

Aufgabe der vorliegenden Erfindung ist es ein bekanntes Nodegehäuse mit Wandungen, die zumindest eine Platine und daran befindliche elektronische Bauteile umschließen, wobei die Wandungen eine Schirmung bereitstellen, wobei das Nodegehäuse über zumindest einen ersten IO-Port für eine erste Übertragungsart und einen zweiten IO-Port für eine zweite Übertragungsart sowie optional über einen Port für eine Stromversorgung (mit oder ohne eine Ausschaltfunktion) verfügt, derart weiterzubilden, dass ein Verändern einer Einstellung oder das Einsetzen beziehungsweise Austauschen eines einzelnen elektronischen Bauteiles oder einer bestimmten elektronischen Bauteilgruppe ermöglicht wird, ohne das ein qualifizierter Techniker vor Ort anwesend sein müsste. Insbesondere soll die Notwendigkeit das Schirmgehäuse zu öffnen und Leitungsunterbrechungen hinnehmen zu müssen vermieden werden. Dokument DE 10 2011 056564 B3 beschreibt ein Nodegehäuse mit den Merkmalen des Oberbegriffs des Anspruchs 1.

Erfindungsgemäß wird diese Aufgabe mit den Merkmalen des Anspruches 1 gelöst. Insbesondere schlägt die Erfindung demnach bei einem gattungsgemäßen Nodegehäuse vor, dass das Nodegehäuse in zumindest einer Wandung eine oder mehrere Aussparungen/Durchtrittsöffnungen aufweist, die neben (zwingend vorhandener) Signalübertragung und optionaler Stromversorgung mit oder ohne Ein-/Aus-Schaltfunktion Zugriff auf zumindest eines der elektronischen Bauteile oder auf eine Bauteilgruppe erlaubt, Zugriff, der die Eigenschaften und/oder die Art des Bauteiles/der Bauteilgruppe im Wesentlichen ohne Übertragungsunterbrechung verändern kann. Die erfindungsgemäße Lösung basiert auf der Erkenntnis, dass eine lokal begrenzte Beeinträchtigung der Schirmwirkung überraschenderweise tolerierbar ist, insbesondere wenn eine lokal begrenzte Aussparung oder Durchtrittsöffnung in einer Wandung mit einem geschlossenen Rand an einem Ort bereitgestellt wird, an dem maßgeblich passive elektronische Bauteile vorliegen. Anders ausgedrückt ist es vorteilhaft, wenn die Schirmwirkung bei den aktiven Bauteilen nicht beeinträchtigt wird, wobei in der Regel auch ein Zugriff auf die aktiven Bauteilen meist nicht erforderlich ist. Im Bereich der Netzwerktechnik ist ein Zugriff auf diejenigen Bauteile, zumindest von technisch nicht hochqualifizierten Kräften gewünscht/erforderlich die z. B den Diplexfilter und den dadurch gegebenen Frequenzen, bzw. Dämpfungsparameter oder den Slope betreffen.

Des Weiteren kann es wünschenswert sein entsprechend den Anforderungen bestimmte Bauteile oder Bauteilgruppen einsetzen zu können. Beispielsweise kann es wünschenswert sein einen Diplexfilter entsprechend den technischen Anforderungen einsetzen zu können. Im Gegensatz zum Stand der Technik, wo ein Gehäuse insgesamt geöffnet und anschließend wieder geschlossen werden muss sieht die erfindungsgemäße Lösung also vor, dass ohne auf das Gehäuse selbst einwirken zu müssen ein Stellrad, ein Dipschalter oder andere Steuerelemente von außen betätigt werden können respektive dass ein Steckplatz zugängig ist um ein elektrisches Bauteil oder eine Bauteilgruppe einstecken zu können, wie z. B. einen Diplexfilter, ohne das ein qualifiziertes Einwirken an anderen Bauteilen erforderlich wäre.

Der Fachmann wird verstehen, dass die eine oder mehrere Aussparungen/Durchtrittsöffnungen vorteilhaft gegenüberstehend zu dem elektronischen Bauteil angeordnet sind, auf welches eingewirkt werden soll. Hierbei kann es sich z. B. um einen Stecksockel, in dem ein Diplexfilter oder eine andere Baugruppeneinheit eingesteckt werden soll handeln. In diesem Fall sollte die entsprechende Aussparung oder Durchtrittsöffnung lokal hierfür begrenzt in der Wandung ausgebildet sein damit insbesondere auch durch den erfolgten Zugriff eine Beeinträchtigung anderer elektronischer Bauteile vermieden oder ausgeschlossen werden kann. Es ist zu verstehen, dass die eine oder mehreren Aussparungen/Durchtrittsöffnungen dazu vorgesehen sind das Verhalten einer oder mehrerer elektronischer Bauteile oder Baugruppen einzustellen oder dauerhaft zu verändern, in dem z. B. ein mit Dipschaltern mögliches Codieren vorgenommen oder verändert werden kann, ein Drehpotentiometer z. B. zur Einstellung einer Dämpfung verstellt werden kann oder wie bereits angesprochen über eine Steckerleiste oder einen Sockel ein optionales oder alternatives Bauteil oder eine entsprechende Bauteilgruppe, z. B. in der Form eines Diplexfilters verwendet werden kann.

Vorteilhafterweise ist zumindest eine Aussparung bemessen und konfiguriert um mit einem an die Aussparung angepassten weiteren Schirmgehäuse wechselwirken zu können. Gerade für den Fall, dass die einen Zugriff ermöglichende Aussparung oder Durchtrittsöffnung ein Einsetzen oder Austauschen von elektronischen Bauteilen ermöglichen soll ist es wünschenswert, die lokal beeinträchtigte Abschirmfunktion wieder zu ergänzen, indem z. B. ein Abschirmcache abgeordnet werden kann, oder in dem z. B. bei einem Zugang zu einem Drehknopf die Oberfläche des Drehknopfes metallisiert wird oder, dass wenn ein Bauteil oder eine Bauteilgruppe, wie z. B. ein Diplexfilter eingesetzt werden soll dieser mit einem eigenen Gehäuse versehen wird, der mit dem verbleibenden Gehäuse kontaktiert werden kann, so dass praktisch eine Schirmwirkung erzielbar ist wie bei einem durchgängigen Gehäuse bar jeglicher Aussparungen/Durchtrittsöffnungen.

Zumindest eine Aussparung stellt im Mündungsbereich eine Überdicke bereit. Das Bereitstellen einer Überdicke kann z. B. eine verbesserte Führung eines Drehknopfes gewährleisten oder auch eine Führung eines einzusteckenden Bauteiles, wenn dieses mit einem entsprechend ausgestalteten Gehäuse versehen wird, wobei ein erhabener Rand auch prinzipiell vorteilhaft sein kann bezüglich der bereitgestellten Schirmwirkung oder um die Integrität des Gehäuses zu verbessern. Entsprechende Überdicken können zudem auf vorgesehen werden bezüglich der Signalübertragungsanschlüsse. Durch das Bereitstellen einer entsprechenden Materialüberdicke (Ausmaß der Vorkragung mit Bezug auf die Wandung) kann z. B. das Verkanten von Stellelementen oder beim Einsetzen von Bauteilen oder Bauteilgruppen vermieden werden, wobei zusätzlich eine Überdicke auch eine größere Kontaktierfläche bereitstellt, wenn die Schirmwirkung komplettiert werden soll.

Obwohl bei effizienten Bauteilen d.h. kleiner Wärmeentwicklung oder bei relativ großen Gehäusen entstehende Wärme auch ohne Wärmerippen abgeführt werden kann ist gemäß einem Aspekt der Erfindung zumindest eine Wandung mit Wärmerippen versehen. Das Bereitstellen von Wärmerippen ermöglicht eine verbesserte Wärmeabfuhr, z. B. insbesondere wenn in dem Bereich der Wandung wo die Wärmerippen vorliegen die aktiven elektronischen Bauteile verbaut sind, so dass über Strahlungswärme und/oder Kontakt mit Wärmeleitfolie/Kühldom die Wandung erwärmt und die Wärme über die Wärmerippen abgeleitet werden kann.

Gemäß einem weiteren Aspekt der Erfindung weist das Nodegehäuse einen oder mehrere Testports auf. Im Gegensatz zu einer Anordnung von Testports, die lediglich mit Messgeräten verbunden werden können, nachdem das Gehäuse geöffnet wurde kann gemäß diesem Aspekt unmittelbar von außen eine Messung an den Testports vorgenommen werden. Beispielhaft kann bei einem Node mit integriertem oder gesteckten Diplexfilter eine Ankopplung der jeweiligen Testports dergestalt erfolgen, dass die jeweiligen durch den Diplexer bedienten Frequenzbereiche abgetastete werden können, so dass eine geeignete Frequenzaufteilung einfach verifiziert werden kann. Insbesondere ist der äußerliche Zugang von Testports im Zusammenhang, das gegebenenfalls technisch weniger qualifiziertes Personal einen Diplexfilter eingesetzt hat oder auch eine andere Dämpfungskarte oder andere elektronische Bauteile oder Bauteilgruppen somit eine einfache Möglichkeit besteht zu verifizieren, ob die vorgenommenen Handhabungen, oder auch Verstellungen über Durchtrittsöffnungen zugänglich und somit verstellten elektrischen Bauteilen das gewünschte Ergebnis zur Verfügung stellen.

Gemäß einem noch weiteren Aspekt der Erfindung der Erfindung ist das Nodegehäuse insgesamt beziehungsweise ein Deckel des Nodegehäuses nicht zerstörungsfrei zu öffnen, so dass das Gehäuse als wartungsfrei bezeichnet werden kann, d. h. das bestimmte elektronische Bauteile im Inneren des Nodegehäuses vor jeglichem unberechtigten Zugriff oder vor einem Zugriff durch nicht geschultes Personal geschützt werden kann, da lediglich diejenigen Bauteile mit Zugriffsmöglichkeit versehen sind, die vom Hersteller für den technisch weniger versierten Benutzer zugängig gestaltet sind, in dem die entsprechenden Aussparungen und/oder Durchtrittsöffnungen an diesen speziellen Ort räumlich begrenzt in der Wandung ausgebildet sind. Ganz im Gegensatz zu den bisher bekannten Lösungen, bei denen das Gehäuse prinzipiell vollständig geöffnet werden musste und somit besondere Vorsichtsmaßnahmen ergriffen werden mussten, um einen unbefugten Zugriff vermeiden zu können bietet eine derartige Lösung somit eine Adaptierungsmöglichkeit, die einfach durchgeführt werden kann, ohne dass qualifiziertes Personal vor Ort anwesend sein müsste und dies zudem mit der Möglichkeit ohne jegliche Leitungsunterbrechung auszukommen. In jedem Fall wird im Stand der Technik durch das vollständige Öffnen des Gehäuses ein erhöhtes Gefährdungspotential dahingehend bestehen, dass auch Bauteile in Mitleidenschaft gezogen werden könnten, die weder einen Zugriff benötigen noch das ein solcher für diese sinnvoll wäre.

Die Erfindung betrifft neben dem Nodegehäuse wie dargelegt auch einen entsprechenden Node für eine breitbandige Übertragung von Signalen mit einem Nodegehäuse gemäß einem beliebigen der vorangehend dargelegten Aspekte der vorliegenden Erfindung. Bei dem Node kann es sich insbesondere um einen optoelektronischen Node handeln, d. h. einen Node bei dem ein erster IO-Port ein optischer IO-Port sein wird, wohingegen ein zweiter IO-Port ein HF oder Koaxialport sein wird. Solche Nodes werden verbreitet angetroffen um z. B. ein Glasfasernetzwerk in ein Hausnetzwerk einzubinden, allerdings ist anzumerken, dass die Erfindung prinzipiell nicht auf optoelektronische Nodes beschränkt ist, sondern vielmehr beliebige Nodes dargestellt werden können, wobei ungeachtet der Konfiguration des Nodes ein selektiver Zugang auf einzelne elektronische Bauteile, z. B. zu Verstellzwecken ebenso gegeben sein kann, wie ein Zugang auf einen Steckplatz oder auch einen Sockel um dort einen Diplexfilter als Bauelementgruppe einzusetzen oder auch um z. B. eine Dämpfungskarte, eine Entzerrerkarte oder andere Filterelemente einzubinden. In diesem Zusammenhang sollte auch angemerkt werden, dass das erfindungsgemäße Konzept eine beliebige Anzahl an Aussparungen/Durchtrittsöffnungen bereitstellen kann, solang diese jeweils definiert in jeweils einer der Wandungen ausgebildet sind, so dass prinzipiell das Gehäuse als geschlossene Einheit die Platine und die Bauelemente umschließt und nach wie vor eine ansonsten geschlossene Einheit mit entsprechender Abschirmwirkung bereitstellt.

Gemäß einem weiteren Aspekt der vorliegenden Erfindung ist zumindest eine Aussparung in dem Nodegehäuse konfiguriert und bemessen um ein elektronisches Bauteil oder eine Bauteilgruppe einsetzten zu können. Wie bereits mehrfach ausgeführt kann es wünschenswert sein einen Diplexfilter steckfähig einzusetzen.

Um eine Fehlausrichtung des Bauteiles oder der Bauteilgruppe zu verhindern ist es z. B. möglich eine spezifische Konfiguration der Aussparung und des einzusetzenden Teiles vorzusehen, so dass ein Einstecken in lediglich einer spezifischen Ausrichtung ermöglicht ist, wohingegen ein Einsetzen in allen anderen Ausrichtungen verhindert wird. Bei einem entsprechenden Einsetzen kann die zuvor erwähnte Überdicke insbesondere auch eine Führung ausbilden, so dass z. B. das einzusetzende Bauteil oder die einzusetzende Bauteilgruppe wie eine Schublade in einem entsprechenden Schacht geführt eingesetzt werden kann.

Besonders vorteilhaft ist bei solch einer Ausgestaltung die Außenkontur des einzusetzenden Bauteiles oder der einzusetzenden Bauteilgruppe als ein Bauteil oder Bauteilgruppengehäuse von metallischer Art auszuführen, so dass die Schirmwirkung bei eingesetztem Bauteil oder eingesetzter Bauteilgruppe bezüglich der Aussparung oder Durchtrittsöffnung komplettiert ist. Sollte kein Bauteil eingesetzt sein ist es selbstverständlich auch möglich einen Kasche oder eine Blindeinheit einzusetzen, die praktisch lediglich aus dem Gehäuse besteht ohne wirksame elektrische Bauteilkomponenten darin.

In Weiterbildungen einer solchen Ausgestaltung ist es besonders vorteilhaft wenn das Nodegehäuse und das Bauteilgehäuse oder Bauteilgruppengehäuse für eine wechselseitige Kontaktierung optimiert sind. Hierbei können insbesondere Rastmittel oder auch ein Vorspannelement zum Einsatz kommen, so dass ein definierter Kontakt und eine definierte Berührung zwischen den einzelnen Teilen gewährleistet werden kann. Rastmittel können auch dazu verwendet werden eine vorbestimmte richtige Positionierung zu bestätigen, oder auch dazu, ein unbeabsichtigtes herausnehmen zu verhindern.

Gemäß einer Weiterbildung ist das einsetzbare Bauteil bzw. die einsetzbare Bauteilgruppe hotplug-fähig einsetzbar. Unter der Begrifflichkeit hotplug-fähig versteht der Fachmann, dass ein Bauteil oder eine Bauteilgruppe in eine Schaltung eingesetzt und daraus entnommen werden kann, ohne das eine Unterbrechung des Betriebes erforderlich wäre. Im Falle einer Entzerrerkarte oder Filterkarte als einsetzbares Bauteil oder als einsetzbare Bauteilgruppe kann solch ein Filter oder Entzerrer in Parallelschaltung zu dem gegebenen Signalpfad optional vorgesehen werden, so dass die Hotplug-Fähigkeit gegeben ist.

Bei einer Anwendung bei der das einsetzbare Bauteil oder die einsetzbare Bauteilgruppe ein streckbarer Diplexfilter oder ein anderes Bauteil oder eine andere Bauteilgruppe ist, die in Serie geschaltet werden muss so kann dies entweder binnen sehr kurzer Zeit und insbesondere ohne Unterbrechung erfolgen, indem entsprechende Maßnahmen ergriffen werden, um diese Hot-Plug-Fähigkeit bereitstellen zu können. Beispielsweise kann ein bereits vorangehend eingesetzter Filter entnommen und durch einen anderen ersetzt werden oder alternativ, wenn auch diesbezüglich eine Hotplugfähigkeit gegeben ist kann z. B. in einer Grundkonfiguration der Node über einen integrierten Diplexfilter verfügen. Sobald ein Diplexfilter zum Einsatz kommen soll ist für einen Benutzer ausreichen den gewählten Diplexfilter in die zu diesem Zwecke ausgebildete Aussparung, z. B. in der Form eines Einschiebeschachtes einzusetzen. Während dem Einsetzen wird elektromechanisch der integrierte Diplexfilter durch den dann eingesteckten Diplexfilter ersetzt, in dem z. B. ein Pin während dem Einstecken die integrierten Diplexschalter kurzschließt. Wenn der eingesetzte Diplexfilter später wieder entnommen wird, würde die Kurzschlussschaltung unmittelbar wieder aufgehoben, so dass der integrierte Diplexfilter praktisch unterbrechungsfrei die Kommunikation der Signale weiterführen kann.

Der Fachmann wird erkennen, dass ein Zugang praktisch durch eine geschlossene Gehäusewandung hindurch für ausgewählte und bestimmte Bauteile und/oder Bauteilgruppen einen deutlichen Fortschritt darstellt, da Adaptionen in einem gewünschten und definiert vorgegeben Umfang auch praktisch ohne technische Vorkenntnisse durchgeführt werden können, ohne das ein Risiko besteht, dass andere Bestandteile des Nodes in Mitleidenschaft gezogen werden bzw. verstellt werden.

Die Möglichkeit zum Beispiel einen Diplexfilter oder andere Karten selektiv von außen stecken zu können, ohne den Node selbst öffnen zu müssen stellt eine erhebliche Einsparung an Installationsdienstleistungsbedarf dar und stellt auch für den Kunden die Möglichkeit bereit eine bestehende Anlage im möglichen Maße zu verstellen, zu erweitern oder zu modifizieren.

Weitere Vorteile und Merkmale der vorliegenden Erfindung ergeben sich ferner aus der nachfolgenden beispielhaften Beschreibung einiger derzeit bevorzugter Ausführungsformen der vorliegenden Erfindung, welche auf die beiliegenden Zeichnungen Bezug nimmt, in welchen gilt:
Figur 1 zeigt in perspektivischer Ansicht ein Nodegehäuse.
Figur 2 zeigt eine Aufsicht eines Nodes, d. h. ein Nodegehäuse im Wesentlichen wie in Figur 1 dargestellt mit darin integrierter Elektronik.
Figur 3 zeigt eine perspektivische Ansicht eines alternativen Nodes, bei dem eine externe Netzteilschaltung vorgesehen ist.
Figur 4 zeigt einen vereinfachten Schaltplan eines optoelektronischen Nodes mit angedeuteter Steckerleiste für einen steckbaren Diplexfilter.

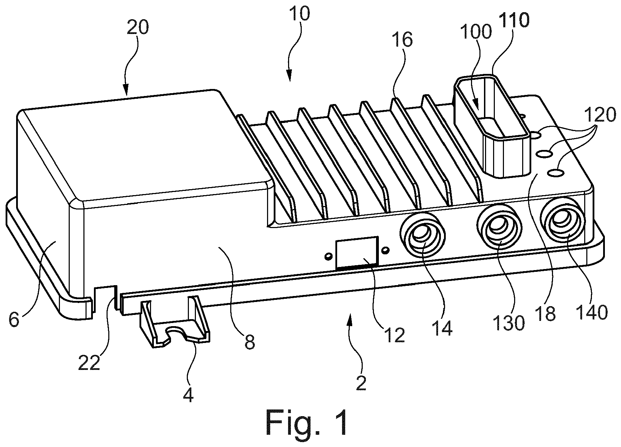

In Figur 1 ist als eine bevorzugte Ausführungsform ein erfindungsgemäßes Nodegehäuse bei einem Bezugszeichen 2 dargestellt. Das Nodegehäuse 2 wird gebildet aus dem dargestellten schalenförmigen Oberteil, z.B. als ein Zinkdruckgussteil mit umlaufenden Wandungen 6, 8 einer nicht dargestellten unteren Wandung (die diesbezüglich entweder unlösbar vereint oder bedingt durch die Positionierung des gesamten Gehäuses bezüglich angrenzender Geometrien nicht zugänglich das Gehäuse ohne ersichtliche Öffnungsmöglichkeit verschließt) und einer oberen Wandung, die nachfolgend im größeren Detail beschrieben wird und mit den Bezugszeichen 10 und 20 identifiziert ist, wobei der obere Wandungsabschnitt 20 eine Netzteilabdeckfläche darstellt und die Wandungsfläche 10 oberhalb einer Platine mit montierten elektrischen Bauteilen befindlich ist. Obwohl nicht dargestellt kann eine Trennung zwischen Netzteilbereich und Hochfrequenzbereich, und insbesondere auch zwischen den entsprechenden Platinen bereitgestellt sein durch eine Trennwandung oder ein Trennblech.

Das Nodegehäuse verfügt auch über Befestigungslaschen, lediglich eine Befestigungslasche ist zur Montage an einer Wand oder in einem Schaltschrank beim Bezugszeichen 4 angedeutet. Bei der Herstellung eines erfindungsgemäßen Nodes wird in dem Gehäuse wie dargestellt eine Platine angeordnet und das Gehäuse wird nach Montage aller erforderlichen elektrischer und elektronischen Komponenten von unten mit einer Basisplatte verschlossen. Nach einer Montage an einer umgebenden Struktur ist diese nicht zugänglich. Alternativ oder Ergänzend ist die Basisplatte mit dem Gehäuse derart verbunden, dass das Gehäuse, beispielsweise ein der umgebenden Struktur zugewandter Deckel nicht oder beziehungsweise nur unter Zerstörung oder zumindest nur mit Anwendung von Gewalt oder Spezialwerkzeug wieder geöffnet werden kann.

In einer der umlaufenden Gehäusewandungen 6, 8, insbesondere der stirnseitigen Wandung 8 ist einerseits eine Ausnehmung 22 vorgesehen, die dazu dient ein Stromkabel einführen zu können. Des Weiteren enthält die seitliche Wandung 8 noch eine Aussparung 12, vorliegend um einen Lichtwellenleiter einbinden zu können und einen Port 14 für eine Koaxialanschluss. Der Port 12 dient somit als erster IO-Port für eine erste Übertragungsart und der Port 14 dient als zweier IO-Port für eine zweite Übertragungsart. Insofern entspricht das Nodegehäuse mit den zuvor genannten Signal- und Stromzufuhr-Eigenschaften im Wesentlichen einem Nodegehäuse wie dieses auch aus dem Stand der Technik bekannt ist. Anders ausgedrückt wäre auch beim Stand der Technik ein Basisteil ausgebildet um entsprechende Signal- und Stromzufuhr-Eigenschaften bereitzustellen, wobei dann allerdings ein aufschraubbarer oder angelenkt vorgesehener Gehäusedeckel das Gehäuse komplettieren würde. Im Gegensatz zum Stand der Technik sieht die Erfindung allerdings vor, dass das Gehäuse nicht durch ein Aufklappen einer Scharnieranordnung, oder lösen einer allgemeinen Schraubverbindung oder anderweitig geöffnet werden kann und auch nicht braucht.

Die Erfindung schlägt jedoch vor, dass zumindest eine weitere Aussparung oder Durchtrittsöffnung vorgesehen ist. Im dargestellten Ausführungsbeispiel umfasst das Nodegehäuse 2 in der stirnseitigen Wandung 8 zwei Test- oder Messports, ausgeführt als koaxiale Anschlussmöglichkeit wie dargestellt bei den Bezugszeichen 130 und 140. Die obere Wandung 10 ist im Bereich der aktiven Elektronikbauteile mit Wärmerippen 16 versehen, wohingegen am distalen Endbereich mehrere Durchtrittsöffnungen im Bereich 18 des oberen Wandungsabschnittes ausgebildet sind, die es ermöglichen diesbezüglich ausgerichtete Verstellmittel, z. B. Drehelemente von Potentiometern durch das geschlossene Gehäuse hindurch zu betätigen. Zwischen dem mit Wärmerippen 16 versehenen Abschnitt und den Einstelldurchtrittsöffnungen 120 ist bei der hier dargestellten Ausführungsform ein Führungsschacht 110 bereitgestellt, an dessen Boden eine relativ großflächige Durchtrittsöffnung 100 ausgebildet ist. Der Schacht 110 und die Durchtrittsöffnung 100 sind vorgesehen um ein elektronisches Bauteil oder eine elektronische Bauteilgruppe einsetzen zu können, so dass diese z. B. über einen Sockel oder eine Steckerleiste an der eingebauten Platine wechselwirken kann, wie dies nachfolgend noch im größeren Detail beschrieben werden wird.

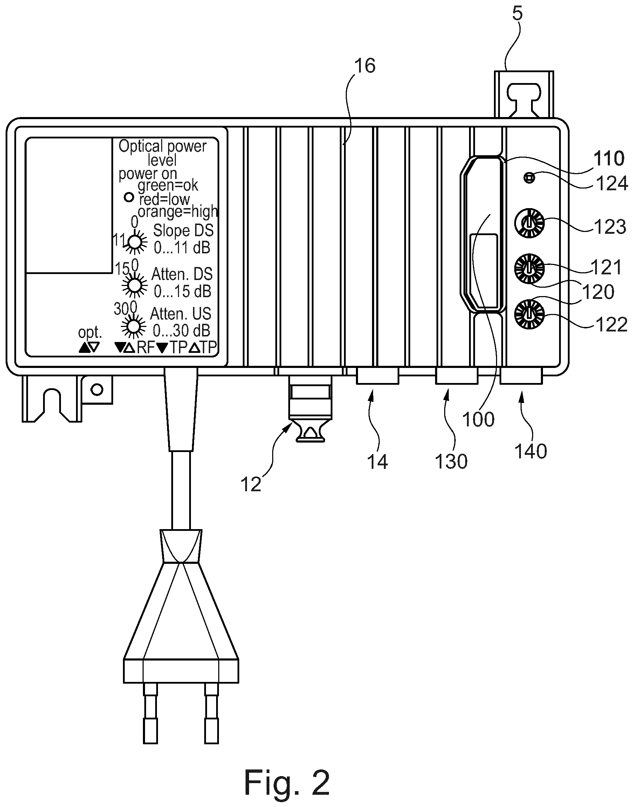

In Figur 2 ist eine Aufsicht eines ausgestatteten Nodes entsprechend dem in Figur 1 gezeigten Gehäuse wiedergegeben, wobei die Stromzufuhr durch ein Kabel dargestellt leicht versetzt worden ist und die Befestigungslasche 4 ebenfalls leicht versetzt worden ist im Vergleich zu der Darstellung von Figur 1. Diagonal gegenüberliegend zur Befestigungslasche 4 ist eine weitere Befestigungslasche 5 ausgebildet wie vorangehend beschrieben ist ein Schacht 110 als Überdicke im Mündungsbereich der Aussparung 100 ausgeführt, so dass ein Steckteil wie z. B. ein Diplexfilter geführt eingeschoben werden kann. Ferner ist deutlich zu erkennen, dass in den Öffnungen 120 Drehsteuerelemente 121, 122 und 123 vorgesehen sind, z. B. um eine Einstellmöglichkeit bereitzustellen von einigen Dezibel für den Slope die Dämpfung downstream oder die Dämpfung upstream. Schließlich ist noch eine Aussparung dargestellt, die es ermöglicht eine Diode 124 zu erkennen, wobei eine solche Aussparung allerdings nicht als Aussparung im Sinne des Patentes verstanden wird, da diese Aussparung einen Zugriff im eigentlichen Sinne nicht erlaubt, allerdings könnte anstelle der Leuchtdiode hier auch ein Dipschalter oder ein anders geartetes Druckschaltelement vorgesehen sein, in welchem Fall es sich dann doch um eine erfindungsgemäße Aussparung handeln würde.

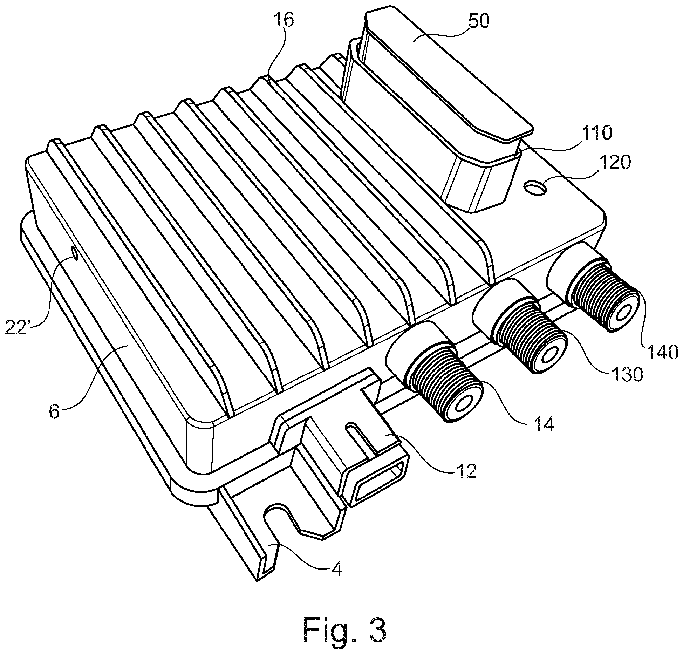

In Figur 3 ist ein Prototyp eines erfindungsgemäßen Nodes als weitere bevorzugte Ausführungsform der Erfindung dargestellt, wobei bei der hier dargestellten Ausführungsform auf ein integriertes Netzgerät verzichtet wurde. Um eine Stromversorgung gewährleisten zu können verfügt die hier dargestellte Ausführungsform somit lediglich über eine Durchtrittsöffnung 22' in der seitlichen Wandung 6. Wie vorangehend ist an der stirnseitigen Wandung 8 wieder eine Fixierlasche 4 vorgesehen, sowie ein optischer Port 12 und ein koaxial Port 14. Die beiden Ports 12 und 14 bilden wie vorangehend einen ersten IO-Port für eine erste Übertragungsart und einen zweiten IO-Port für eine zweite Übertragungsart. Wie vorangehend ist zusätzlich an der stirnseitigen Wandung 8 jeweils ein Test- oder Messport 130 bzw. 140 s ausgebildet für jeweils up und down. Wie vorangehend ist die obere Wandung mit Wärmerippen 16 und in dem Wärmerippen freien Bereich 18 sind Durchgangsöffnungen 120 ausgebildet sowie ein Schacht 110, der im unteren Bereich eine Durchtrittsöffnung 100 aufweist, die hier nicht zu erkennen ist, da in dem Schacht ein Diplexfilter angedeutet mit dem Bezugszeichen 50 eingeführt ist.

Der Diplexfilter 50, der hier als lediglich Beispielhaft für eine Vielzahl von möglichen elektronischen Bauteilen oder Bauteilgruppen dargestellt ist verfügt über ein eigenes metallisches Gehäuse, welches mit der Überdicke oder dem Schacht 110 einerseits eine Führung ermöglicht um den Diplexfilter ohne Risiko einer Verkantung einführen zu können und andererseits eine Kontaktierung ermöglicht, so dass die Schirmung, die durch das Gehäuse insgesamt bereitgestellt wird durch das Gehäuse des Diplexfilters komplettiert wird. Es ist zu erwähnen, dass trotz der beispielhaft angegebenen Diplexfilterkonfiguration auch andere Steckkarten oder elektronische Bauteile wie dargestellt eingesteckt werden können.

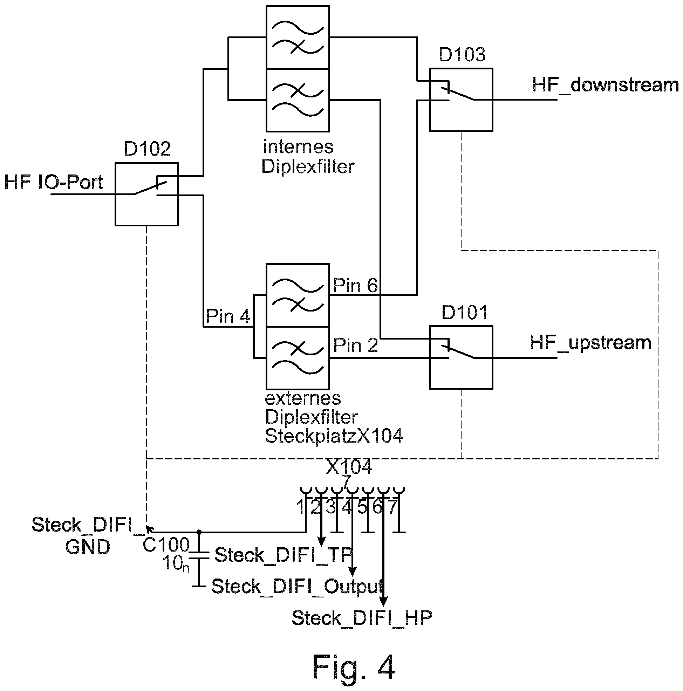

In Figur 4 ist ein vereinfachtes Schaltdiagramm des in Figur 3 dargestellten Nodes wiedergeben, wobei auch die Steckkontaktleiste mit entsprechender Belegung angegeben ist. Wenn der erfindungsgemäße Node mit dem erfindungsgemäßen Nodegehäuse als z. B. in einem Gebäude installiert wurde um an das öffentliche Glasfasernetz angeschlossen zu werden vermittels der Ports 12 und um nach entsprechender Wandlung im inneren des Gehäuses Daten ein- und ausgeben zu können vermittels des Koaxialports 14, so kann ein Benutzer, auch ohne technische Kenntnisse z. B. unter Anleitung durch eine Hotline z. B. die Verstellräder die zugänglich sind über die Durchtrittsöffnungen 120 mit einem kleinen Schraubendreher betätigen, um z. B. das Slope oder die Downstream-Dämpfung oder die Upstream-Dämpfung einzustellen, je nachdem welche baulichen Gegebenheiten und insbesondere Kabellängen im Gebäude angetroffen werden.

Über die Ports 130, 140 kann z. B. eine Fernwartung angeschlossen sein oder der Benutzer kann die Signale aus dem Inneren des Nodes auslesen. Eine solche Auslesemöglichkeit war bisher nur möglich wenn insgesamt Zugang zur Elektronik erhalten worden war nachdem man einen entsprechenden Gehäusedeckel geöffnet hatte. Im Inneren des Gehäuses und wie im Schaltplan von Figur 4 zu erkennen ist beinhaltet der erfindungsgemäße Node der hier dargestellten Ausführungsform einen festverdrahteten integrierten Diplexfilter. Somit ist der Node nach Installation und Beschaltung der Ports 12, 14 einsatzbereit. Sollte der Kunde oder Benutzer nun eine andere Frequenzaufteilung wünschen oder benötigen als dies durch den integrierten Diplexfilter bereitgestellt wird so ist es ihm z. B. möglich ein Diplexfiltermodul über den Schacht 110 in die Aussparung 100 einzusetzen. Beim Einsetzen des Diplexfiltermoduls werden entsprechende Kontakte in die Sockelleiste wie in Figur 4 dargestellt eingeführt. Einer der eingeführten Stifte führt dann synchron mit der Einführung und der Schaltung des eingesetzten Diplexfilters zu einem Kurzschließen oder auf Masse setzen des integrierten Diplexfilters, so dass die Änderung praktisch als Hotplug-Anwendung erfolgen kann, d. h. ohne dass es zu einer Leitungsunterbrechung kommen würde.

Wie der Fachmann dem Schaltplan entnehmen kann liegt der gemeinsame Port des Diplexfilters am hochisolierenden Schalter D102 an. Dieser schaltet zwischen dem gemeinsamen Port des internen und externen Diplexfilters. Die jeweiligen Ausgänge des Hoch- und Tiefpasses des internen und externen Diplexfilters werden zeitgleich zu D102 mit den HF-Schaltern D101 und D103 geschaltet. Wenn kein externes Diplexfilter gesteckt ist, ist das interne aktiv. In diesem Fall haben diese HF-Schalter folgende Beschaltung (Potential "Steck_DIFI_GND" = +5V): D101: Pin4 liegt an +5V (=high); Transistor V105 ist geöffnet -> Pin6 liegt an GND (=low); D102: Pin10 liegt dauerhaft an 3,1V (=high); Pin11 liegt an 3,1V (=high); D103: Pin4 liegt an +5V (=high); Transistor V107 ist geöffnet -> Pin6 liegt an GND (=low)

Die Buchsenleiste X104 ist der Steckplatz für das vorgehaltene, optionale Diplexfilter. Ihr Pin1 liegt standardmäßig auf dem Potential "Steck_DIFI_GND".

Wird nun das externe Diplexfilter gesteckt, so wird dieses Potential auf Masse gezogen. Die Beschaltung der drei HF-Schalter ist dann folgende:
D101: Pin4 liegt an GND (=low); Transistor V105 ist geschlossen -> Pin6 liegt an +5V (=high); D102: Pin10 liegt dauerhaft an 3,1V (=high); Pin11 liegt an GND (=low);
D103: Pin4 liegt an GND (=low); Transistor V107 ist geschlossen -> Pin6 liegt an +5V (=high)

Wird das externe Diplexfilter gezogen, wird das Potential "Steck_DIFI_GND" wieder auf +5V gezogen und die erste Beschaltung wird wieder hergestellt.

Sollte der Benutzer später einen noch anderen Diplexfilter wünschen so könnte er einfach den Diplexfilter wieder entnehmen, so dass der integrierte Diplexfilter wieder in Betrieb gelangt wie zuvor beschrieben. Sobald ein anderer Diplexfilter vom Benutzer gewählt und eingesetzt wird erfolgt wiederum ein auf Masse setzen oder kurzschließen des integrierten Diplexfilters zeitgleich mit der Schaltung des dann neu eingesetzten alternativen Diplexfilters.

Der Fachmann wird erkennen, dass im Rahmen der Erfindung verschiedene Veränderungen und Modifikationen möglich sind, ohne von dem Umfang der Erfindung wie vorliegend offenbart abzuweichen. Insbesondere wird der Fachmann erkennen, dass anstelle eines einsetzbaren Diplexfilters auch andere elektronische Bauteile oder Bauteilgruppen zum Einsatz kommen können. Wesentlich für die Erfindung ist letztendlich das eine Interaktion mit ausgewählten Bestandteilen des Nodes gewährleistet wird, wohingegen andere Bereiche unzugänglich verbleiben. Die Erfindung wurde vorrangehend unter Bezugnahme auf den Begriff Node beschrieben, welcher im Sinne der Vorliegenden Anmeldung auch als Verstärker bzw. als Node mit Verstärker zu verstehen ist. Neben der Weiterbildung die als besonders vorteilhaft angesehen wird, dass auch eine Hotplug-Fähigkeit gegeben ist gewährleistet die erfindungsgemäße Anordnung eine reduzierte Gefährdung von elektronischen Bauteilen und führt somit zur Reduzierung, wenn nicht vollständig fehlenden Leitungsunterbrechungen.

## Patentansprüche

1. Nodegehäuse (2) mit Wandungen (6, 8 ,10, 20), die zumindest eine Platine und daran befindliche elektronische Bauteile umschließen, wobei die Wandungen eine Schirmung bereitstellt, wobei das Nodegehäuse über zumindest einen ersten I/O-Port (12) für eine erste Übertragungsart und zumindest einen zweiten I/O-Port (14) für eine zweite Übertragungsart sowie optional über einen Port (22) für eine Stromversorgung mit oder ohne ein/aus-Schaltfunktion verfügt, wobei das Nodegehäuse in zumindest einer Wandung eine oder mehrere Aussparungen/Durchtrittsöffnungen (100, 120, 130, 140) aufweist, die neben Signalübertragung und optionaler Stromversorgung mit oder ohne ein/aus-Schaltfunktion Zugriff auf zumindest eines der elektronischen Bauteile erlaubt, Zugriff, der die Art und/oder Eigenschaften des Bauteiles im Wesentlichen ohne Übertragungsunterbrechung verändern kann,
**dadurch gekennzeichnet, dass** zumindest eine Aussparung (100) im Mündungsbereich eine Überdicke (110) bereitstellt,
wobei die Überdicke einen erhabenen Rand bereitstellt, um die Integrität des Gehäuses zu verbessern,
wobei die Überdicke (110) ein Ausmaß der Vorkragung mit Bezug auf die Wandung darstellt, die auch eine größere Kontaktierfläche bereitstellt, die die bereitgestellte Schirmwirkung verbessert.

2. Nodegehäuse nach Anspruch 1, **dadurch gekennzeichnet, dass** zumindest eine Aussparung (100) bemessen ist, um mit einem an die Aussparung angepassten weiteren Schirmgehäuse wechselwirken zu können.

3. Nodegehäuse nach einem der Ansprüche 1 bis 2, **dadurch gekennzeichnet, dass** Zumindest eine Wandung (10) mit Wärmerippen (16) versehen ist.

4. Nodegehäuse nach Anspruch 1 bis 2, **dadurch gekennzeichnet, dass** zumindest eine Aussparung (120) in einem wärmerippenfreien Bereich (18) befindlich ist.

5. Nodegehäuse nach einem der Ansprüche 1 bis 4, **dadurch gekennzeichnet, dass** es einen oder mehrere von Testports (130, 140) aufweist.

6. Nodegehäuse nach einem der Ansprüche 1 bis 5, **dadurch gekennzeichnet, dass** das Gehäuse eine geschlossene Einheit darstellt, die nicht zerstörungsfrei oder zumindest nicht ohne Demontage des Gehäuses von umgebenden Strukturen oder nicht ohne Spezialwerkzeug zu öffnen ist.

7. Node für breitbandige Übertragung von Signalen mit einem Nodegehäuse nach einem der vorangehenden Ansprüche.

8. Node nach Anspruch 7, einen integrierten Diplexfilter enthaltend.

9. Node nach Anspruch 7 oder 8, wobei zumindest eine Aussparung (100) konfiguriert und bemessen ist, um ein elektronisches Bauteil einsetzen zu können.

10. Node nach Anspruch 9 konfiguriert um das einsetzbare Bauteil hotplug-fähig einsetzen zu können.

11. Node nach Anspruch 9 oder 10, wobei das einsetzbare Bauteil ein steckbarer Diplexfilter ist.

## Claims

1. A node housing (2) with walls (6, 8, 10, 20) enclosing at least one circuit board and electronic components located thereon, the walls providing shielding, wherein the node housing has at least one first I/O port (12) for a first transmission type and at least one second I/O port (14) for a second transmission type and optionally a port (22) for a power supply with or without an on/off switching function, the node housing having one or more recesses/passages (100, 120, 130, 140) in at least one wall which, in addition to signal transmission and optional power supply with or without an on/off switching function, permits access to at least one of the electronic components, access which can change the type and/or properties of the component essentially without interrupting transmission,
**characterised in that** at least one recess (100) in the opening region provides an overthickness (110),
wherein the overthickness provides a raised edge to improve the integrity of the housing,
wherein the overthickness (110) represents an extent of the projection with respect to the wall, which also provides a larger contact surface which improves the provided shielding effect.

2. The node housing according to claim 1, **characterized in that** at least one recess (100) is dimensioned to interact with a further shielding housing adapted to the recess.

3. The node housing according to one of claims 1 to 2, **characterized in that** at least one wall (10) is provided with thermal ribs (16).

4. The node housing according to claims 1 to 2, **characterized in that** at least one recess (120) is located in an area (18) free of thermal ribs.

5. The node housing according to any one of claims 1 to 4, **characterized in that** it has one or more of test ports (130, 140).

6. The node housing according to one of claims 1 to 5, **characterized in that** the housing is a closed unit which cannot be opened non-destructively or at least not without dismantling the housing from surrounding structures or not without special tools.

7. A node for broadband transmission of signals with a node housing according to one of the preceding claims.

8. The node according to claim 7, comprising an integrated diplex filter.

9. The node according to claim 7 or 8, wherein at least one recess (100) is configured and dimensioned to insert an electronic component.

10. The node according to claim 9 configured to hot-pluggable insert the insertable component.

11. The node according to claim 9 or 10, wherein the insertable component is a pluggable diplex filter.

## Revendications

1. Boîtier de nœud (2) ayant des parois (6, 8, 10, 20) qui encerclent au moins une carte et des composants électroniques situés sur celle-ci, dans lequel lesdites parois assurent un blindage, dans lequel ledit boîtier de nœud a au moins un premier port d'entrée/sortie I/O (12) pour un premier mode de transmission et au moins un deuxième port d'entrée/sortie I/O (14) pour un deuxième mode de transmission, et en option un port (22) pour une alimentation électrique avec ou sans fonction de commutation marche/arrêt, dans lequel le boîtier de nœud comporte, dans au moins une paroi, un/une ou plusieurs évidements/ouvertures de passage (100, 120, 130, 140) qui, outre la transmission de signaux et l'alimentation électrique optionnelle avec ou sans fonction de commutation marche/arrêt, permettent d'accéder à au moins un des composants électroniques, accès qui peut modifier le type et/ou les propriétés du composant sans sensiblement interrompre la transmission,
**caractérisé en ce qu'**au moins un évidement (100) fournit une surépaisseur (110) dans la zone d'ouverture,
dans lequel la surépaisseur fournit un bord surélevé pour améliorer l'intégrité du boitier,
dans lequel la surépaisseur (110) représente une quantité de projection par rapport à la paroi qui fournit également une plus grande surface de contact qui améliore l'effet de blindage fourni.

2. Boîtier de nœud selon la revendication 1, **caractérisé en ce qu'**au moins un évidement (100) est dimensionné pour pouvoir interagir avec un autre boitier de blindage adapté à l'évidement.

3. Boîtier de nœud selon l'une des revendications 1 à 2, **caractérisé en ce qu'**au moins une paroi (10) est pourvue de nervures thermiques (16).

4. Boîtier de nœud selon les revendications 1 à 2, **caractérisé en ce qu'**au moins un évidement (120) est situé dans une zone (18) exempte de nervures thermiques.

5. Boîtier de nœud selon quelconque l'une des revendications 1 à 4, **caractérisé en ce qu'**il possède un ou plusieurs ports de test (130, 140).

6. Boîtier de nœud selon l'une quelconque des revendications 1 à 5, **caractérisé en ce que** le boitier est une unité fermée qui ne peut pas être ouverte sans dommages ou du moins pas sans démonter le boitier des structures environnantes ou sans outil spécial.

7. Nœud pour la transmission de signaux à large bande avec un boîtier de nœud selon l'une des revendications précédentes.

8. Noeud selon la revendication 7, contenant un filtre diplex intégré.

9. Noeud selon la revendication 7 ou 8, dans lequel au moins un évidement (100) est configuré et dimensionné pour permettre l'insertion d'un composant électronique.

10. Nœud selon la revendication 9 configuré pour pouvoir brancher à chaud le composant insérable.

11. Noeud selon la revendication 9 ou 10, dans lequel le composant insérable est un filtre diplex enfichable.
